# EUROPEAN PATENT SPECIFICATION

(11) **EP 2 124 299 B1**
(45) Date of publication and mention of the grant of the patent: **11.05.2011**
(21) Application number: 09160890.1
(22) Date of filing: 22.05.2009
(51) Int. Cl.: H01R 13/648

(54) **Removable memory card**
Entfernbare Speicherkarte
Carte mémoire amovible

(30) Priority: 22.05.2008 JP 2008133760
(43) Date of publication of application: 25.11.2009
(73) Proprietor: Panasonic Corporation, Osaka 571-8501 (JP)
(72) Inventor: Suenaga, Hiroshi, Osaka 540-6207 (JP); Saito, Yoshiyuki, Osaka 540-6207 (JP); Shibata, Osamu, Osaka 540-6207 (JP); Fukumoto, Yukihiro, Osaka 540-6207 (JP)
(74) Representative: Eisenführ, Speiser & Partner

(56) References cited:
- EP-A- 1 058 216
- EP-A- 1 387 445
- JP-A- 60 153 583
- US-A- 5 892 216

## Description

### BACKGROUND OF THE INVENTION

### FIELD OF THE INTENTION

The present invention relates to a removable memory card, more particularly to a card structure designed to avoid electrostatic breakdown caused by contact with a human body, etc.

### DESCRIPTION OF THE RELATED ART

Most of removable memory cards comprise exposed terminals, and a user's fingertips possibly contact these terminals when he/she handles these cards. In the case where static electricity has already been accumulated in the user's body and contact is made with a removable memory card, an LSI provided in the removable memory card connected to the terminals may breakdown due to the static electricity.

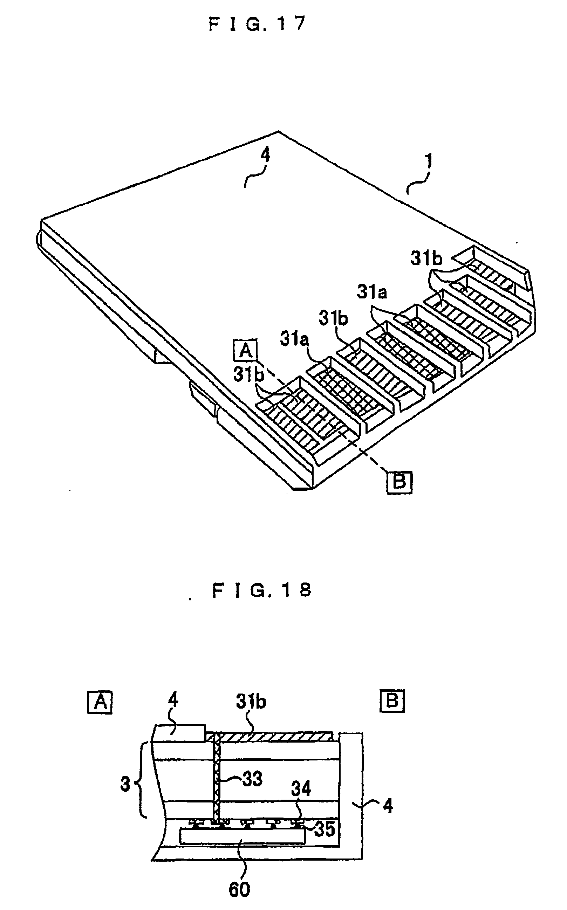

In order to deal with the problem, in a removable memory card illustrated in Fig. 17 and Fig. 18 (a sectional surface of the card illustrated in Fig. 17 out along A - B line), for example, a diode for eliminating static electricity is conventionally connected to an I/O circuit in an Large Scale Integration (LSI) circuit 60 directly connected to terminals 31b of the removable memory card. In this structure, when static electricity intrudes into the removable memory card, the static electricity is bypassed such that it is discharged through the diode to a stable potential such as a ground or power-supply potential. As a result, the protection of the LSI 60 is carried out.

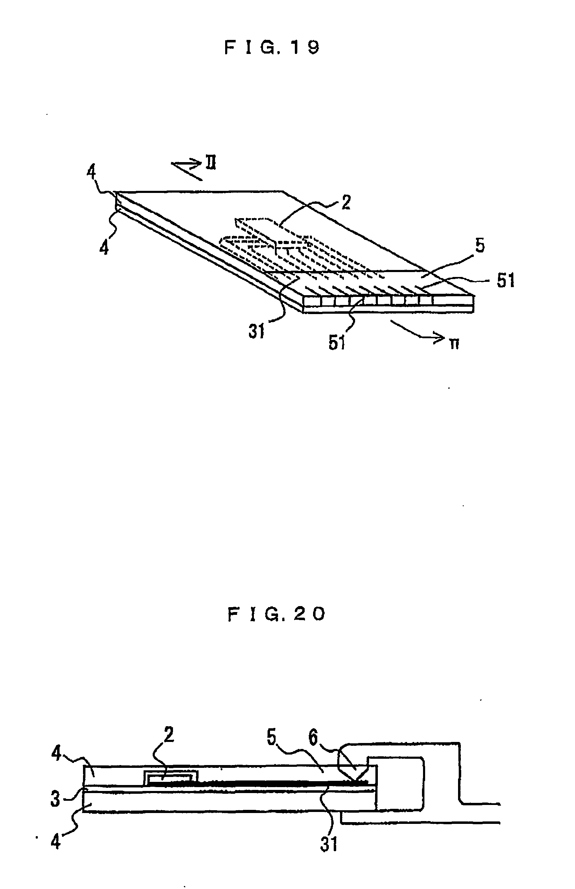

There is another technology concerning the problem, which is recited in the disclosed Japanese patient documents (60-153583 of the Japanese Patent Applications Laid-Open). A removable memory card wherein the technology is adopted is illustrated Figs. 19 and 20. Fig. 19 is a perspective view of the removable memory card, while Fig. 20 is a sectional view of Fig. 19 out long II - II line. In Fig. 19, terminals 31 of the removable memory card are coated with an elastomer layer 5 provided with notches 51. When the removable memory card is not connected to a reading device, the notches 51 are kept blocked due to the elasticity of the elastomer layer 5. When the removable memory card is connected to the reading device, a contact point 6 of the reading deviate advances into the notches 51 of the elastomer layer 5 to come into contact with and make connections to the terminals 31, as illustrated in Fig. 20. Accordingly, any contact between the fingertips, or the like, and the terminals can be prevented when the removable memory card is removed from the reading device.

A diode for eliminating static electricity needs to have such a load capacity as a few pF at least or approximately 10 pF at most. When the diode having such a large load capacity is provided, however, impedance mismatch occurs in a transmission wire. A transmission rate in the conventional removable memory card described earlier is as relatively low as approximately a few tens of Mbps/ch. Therefore, the provision of the diode for eliminating static electricity did not present a serious problem in dealing with impedance mismatch in a transmission wire due to its load capacity. However, removable memory cards now available have such a large memory capacity as a few gigabytes, and the memory capacity is expected to be further increased in the future. Along with the increasing memory capacity, the transmission rate of a removable memory card has become higher. Under the current circumstances, the load capacity of a diode for eliminating static electricity is becoming an inhibition in the pursuit of a higher transmission rate.

Furthermore, when the conventional technology is applied, it is indispensable to secure a large area for providing the elastomer layer 5. However, the increase of the memory capacity of a removable memory card necessitates the demand that a large mounting area to be secured for a flash memory provided in the removable memory card. Securing a flash memory mounting area has priority over the installation of the elastomer layer 5. As a result, an adequately large area cannot be allowed for the elastomer layer 5 to be attached, and there is a high possibility that the elastomer layer 5 is peeled off.

### SUMMARY OF THE INVENTION

Therefore, a main object of the present invention is to provide a removable memory card having a structure wherein the protection of an internal circuit and the transmission of a high-speed signal can be both realized.

In order to accomplish the main object, a removable memory card according to the present invention has such a structure that terminals for transmitting high-speed signals (these terminals correspond to a first terminal) are provided at positions lower than positions of terminals for transmitting low-speed signals and power-supply / ground terminals (these terminals correspond to a second terminal).

According to the constitution, when an object charged with static electricity, such as a human body, contracts the removable memory card, the electrostatically-charged object contacts the second terminal (terminals for transmitting low-speed signals and power-supply / ground terminals) before contacting the first terminals (terminals for transmitting high-speed signals). Therefore, the static electricity accumulated in the object can be flowed to the side of the second terminal. As a result, it becomes unnecessary to provide a diode for eliminating static electricity having a large load capacity in an I/O circuit portion in an LSI which are connected to the first terminals (terminals for transmitting high-speed signals)and a bypass wire.

According to the removable memory card provided by the present invention, impendance mismatch occurring in the transmission path connected to the terminals for transmitting high-speed signals (the first terminal) can be alleviated, and the electrostatic protection performance can be retained at the same time. As a result, a transmission rate of the removable memory card is improved.

The removable memory card according to the present invention, wherein the impedance mismatch occurring in the transmission path connected to the terminals for transmitting high-speed signals can be alleviated, and the electrostatic protection performance can be retained at the same time, is useful to improving its transmission rate.

### BRIEF DESCRIPTION OF THE DRAWINGS

Fig. 1 is an illustration of an example of a removable memory card according to a preferred embodiment 1 of the present invention.
Fig. 2 is an illustration of an example of a sectional surface of the removable memory card illustrated in Fig. 1.
Fig. 3 is a configuration diagram wherein electrostatic breakdown is controlled.
Fig. 4 is an illustration of an example of the removable memory card according to the preferred embodiment 1.
Fig. 5 is an illustration of an example of a sectional surface of the removable memory card illustrated in Fig. 4.
Fig. 6 is an illustration of an example of the removable memory card according to the preferred embodiment 1.
Fig. 7 is an illustration of an example of a sectional surface of the removable memory card illustrated in Fig. 6.
Fig. 8 is an illustration of an example of a removable memory card according to a preferred embodiment 2 of the present invention.
Fig. 9 is an illustration of an example of a sectional surface of the removable memory card illustrated in Fig. 8.
Fig. 10 is an illustration of an example of the removable memory card according to the preferred embodiment 2.
Fig. 11 is an illustration of an example of a sectional surface of the removable memory card illustrated in Fig. 10.
Fig. 12 is an illustration of an example of the removable memory card according to the preferred embodiment 2.
Fig. 13 is an illustration of an example of a sectional surface of the removable memory card illustrated in Fig. 12.
Fig. 14A is a perspective view of a first modified embodiment of the present invention.
Fig. 14B is a perspective view of a second modified embodiment of the present invention.
Fig. 14C is a perspective view of a third modified embodiment of the present invention.
Fig. 15 is a sectional view used for the description of effects obtained by the first - third modified embodiments.
Fig. 16 is a sectional view of a fourth modified embodiment of the present invention.
Fig. 17 is an illustration of a conventional technology associated with the control of the electrostatic breakdown of a removable memory card.
Fig. 18 is a sectional view of the removable memory card illustrated in Fig. 17.
Fig. 19 is an illustration of another conventional technology associated with the control of the electrostatic breakdown of a removable memory card.
Fig. 20 is a sectional view of the removable memory card illustrated in Fig. 19.

### DETAILED DESCRIPTION OF THE INVENTION

Hereinafter, preferred embodiments of the present invention are described referring to the drawings.

### PREFERRED EMBODIMENT 1

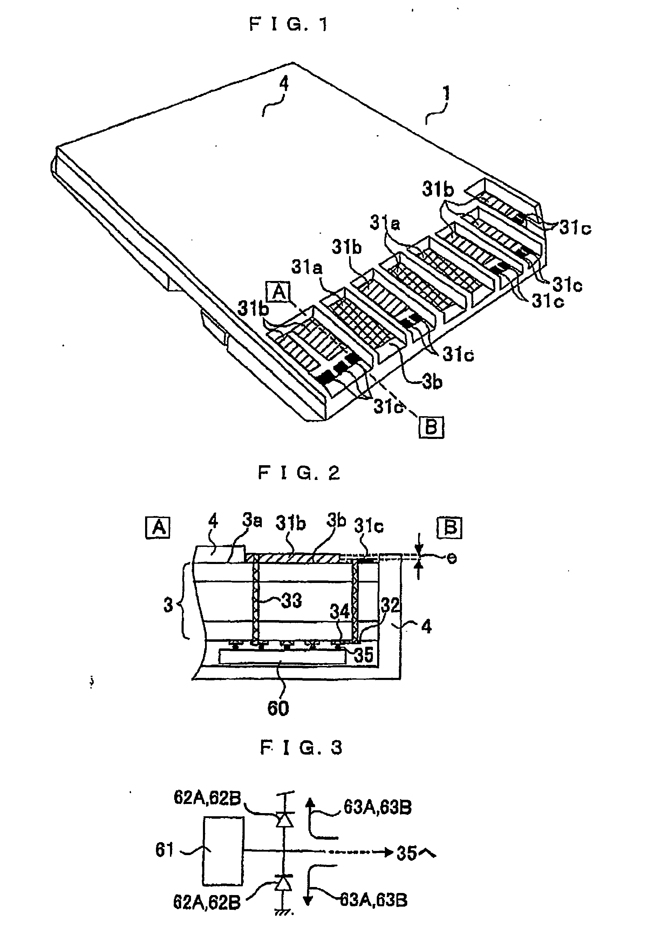

Fig. 1 is a perspective view of an example of a removable memory card according to a preferred embodiment 1 of the present invention. Fig. 2 is a sectional view of Fig. 1 cut along A - B line. The removable memory card according to the present preferred embodiment comprises a printed substrate 3. Terminals 31a, 31b and 31c used for convection to an outside host device are provided on a terminal formation surface 3a of the printed substrate 3. The terminals 31a, 31b and 31a are placed in a terminal setting section 3b provided at an end portion of the terminal formation surface 3a. On the printed substrate 3, an LSI 60 is mounted by means of solder bumps 35 or the like. The LSI 60 controls the read and write of data with respect to a flash memory (not shown) provided in the removable memory card 1 in response to requests such as data READ / WRITE from the outside host device (not shown). The LSI 60 is connected to the terminals 31a, 31b and 31c by means of a via 33 in the printed substrate 3 and wiring lines 32. The printed substrate 3 thus constituted is covered with a sheet 4 made of hard PVC (polyvinyl chloride) or the like.

The terminals 31a, 31b and 31c are as follows: a power-supply / ground terminal 31a, a terminal 31b for low-speed signal and a terminal 31c for high-speed signal. In the present preferred embodiment, the terminal 31a for high-speed signal constitute a first terminal, while the power-supply / ground terminal 31a and the terminal 31b for low-speed signal constitutes a second terminal. The removable memory card 1 according to the present preferred embodiment is further provided with first and second bypass wires 63A and 63B as illustrated in Fig. 3. The second bypass wire 63B drops the static electricity having intruded into the terminal 31b for low-speed signal to a stable potential (a power-supply or ground potential) through a second diode 62B so that the static electricity is not inputted to an I/O circuit 61 in the LSI 60. The first bypass wire 63A drops the static electricity having intruded into the terminals 31c for high-speed signal to a stable potential (power supply or ground potential) through a first diode 62A so that the static electricity is not inputted to the I/O circuit 61 in the LSI 60. As the second diode 62B to be provided in the second bypass wire 63B is used a diode having a high pressure resistance and a large load capacity. On the other hand, as the first diode 62A to be provided in the first bypass wire 63A is used a diode having a small load capacity.

A transmission rate of a signal inputted from outside (host device or the like) to the terminals 31b for low-speed signal is approximately a few tens of Mbps/ch which is relatively low, while a transmission rate of a signal inputted from outside (host device or the like) to the terminals 31a for high-speed signal is very high, approximately a few giga bps/ch.

The present preferred embodiment is characterized in thicknesses of the terminals 31a, 31b and 31c. More specifically, the thickness of each of the power-supply / ground terminal 31a and the terminal 31b for low-speed signal is set to be lager than the thickness of the terminal 31c for high-speed signal. To realize the different thickness, for example, an arrangement is made to a metal plating process. More specifically, when surfaces of the terminals 31a, 31b and 31c are metal-plated, the surface of each of the terminal 31b for low-speed signal and the power supply and ground terminal 31a (second terminal) is metal-plated in a thickness larger than that of the surface of the terminal 31c for high-speed signal (first terminal) so that a difference in thickness is generated between the first and second terminals. In other words, a difference in the setting height position and a difference in the height position of the terminal surface (level difference e) are provided between the first and second terminals.

According to the constitution, when an electrostatically-charged user operates the removable memory card 1, and his/her fingertips, for example, contact the terminals 31a, 31b and 31c, the fingertips first contact the terminal 31b for low-speed signal which is thicker than the others. Therefore, the static electricity accumulated in the user' s body flows through the terminal 31b for low-speed signal into the second diode 62B provided in the second bypass wire 63B, and further is discharged through the second diode 62B to the stable potential (power-supply potential or ground potential), or is discharged through the power-supply /ground terminal 31a to the stable potential. Accordingly, the I/O circuit 61 of the LSI 60 is protected from the static electricity.

In this case, because the transmission rate in the transmission of the signal through the terminal 31b for low-speed signal is low, impedance mismatch in the transmission path is not a major concern. On the other hand, because the transmission rate in the transmission of the signal through the terminal 31c for high-speed signal is high, the impendance mismatch in the transmission path can be a serious problem. In view of this, the following constitution has been provided in the present preferred embodiment as described earlier. In the second bypass wire 63B to which the terminals 31b for low-speed signal are connected, the second diode 62B having a sufficiently high pressure resistance and a large load capacity is provided. On the other hand, in the first bypass wire 63A to which the terminals 31c for high-speed signal are connected, the first diode 62A having a reduced load pressure resistance and a small load capacity is provided. According to the constitution, the intrusion of the static electricity can be presented while the impedance matching in the transmission path to which the terminals 31c for high-speed signal are connected is successfully maintained. Here, the first diode 62A and the second diode 62B are examples of elestrostatic protection device and, in addition to these, varistor etc. is mentioned as electrostatic protection device.

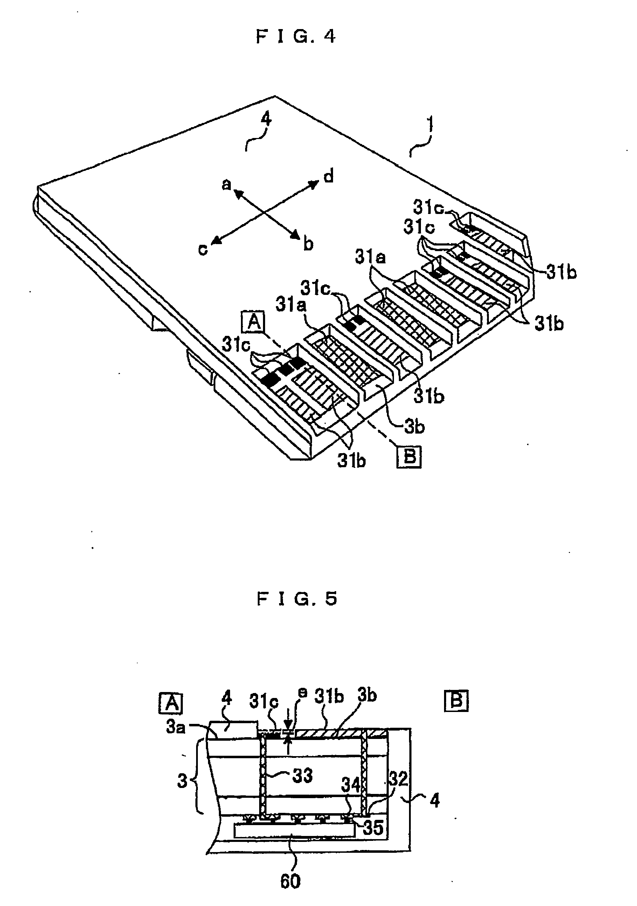

As illustrated in Figs. 4 and 5, the terminals 31b for low-speed signal may be provided on the end side of the removable memory card 1 along a direction in which the terminals are arranged, and the terminals 31c for high-speed signal may be provided on the center side of the removable memory card 1. By doing so, it can be more difficult for a human body, such as his/her fingertips, to contact the terminals 31c for high-speed signal. As a result, the I/O circuit (I/O circuit for high-speed signals) in the LSI 60 can be more effectively protected from the static electricity. The direction in which the terminals are arranged in the removable memory card 1 includes both of a - b direction and c - d direction illustrated in Fig. 4.

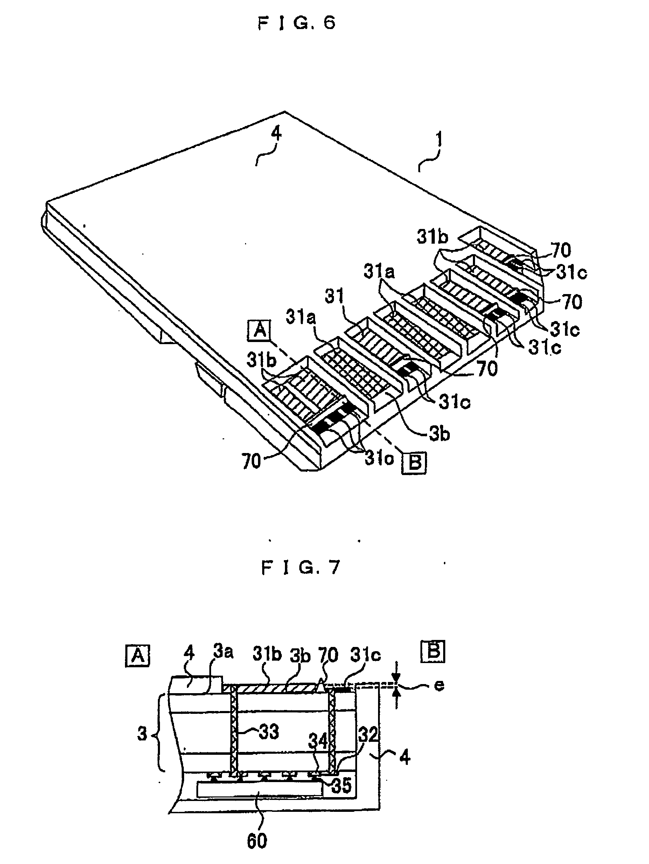

As illustrated in Figs. 6 and 7, partitions 70 having a larger height dimension than the peripheral portions and protruding upward from the printed substrate 3 may be provided between the terminals 31b for low-speed signal and the terminals 31c for high-speed signal adjacent to each other to make it more difficult for the human body, such as his/her fingertip, to contract the terminals 31c for high-speed signal. As a result, the I/O circuit (I/O circuit for high-speed signal) in the LSI 60 can be more effectively protested from the static electricity. The partition 70 may be formed such that the sheet 4 made of hard PVC or the like and serving as the cover of the removable memory card, for example, is modified.

### PREFERRED EMBODIMENT 2

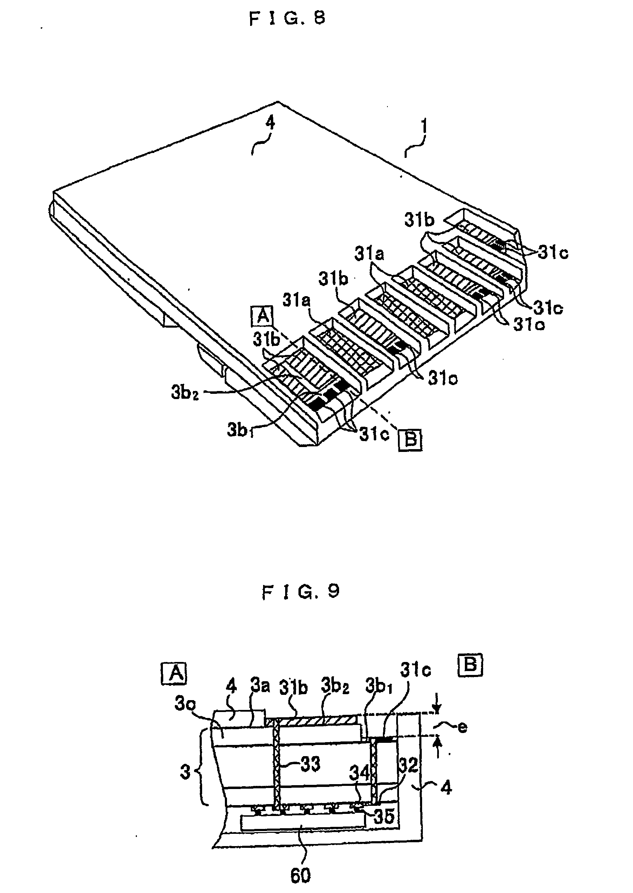

Fig. 8 is a perspective view of an example of a removable memory card according to a preferred embodiment 2 of the present invention. Fig. 9 is a sectional view of Fig. 8 cut among A - B line. The I/O circuit in the LSI 60, which is constituted in the same manner as in Fig. 3, is not shown in the drawings. In the removable memory card according to the present preferred embodiment, terminals 31a, 31b and 31c used for connection to an outside host device (not shown) are provided on a surface of a printed substrate 3. On the printed substrate 3, an LSI 60, which controls the read and write of data with respect to a flash memory (not shown) provided in the removable memory card 1 in response to requests such as data READ / WRITE from the outside host device, is mounted by means of solder bumps 35 or the like.

The LSI 60 is connected to the terminals 31a, 31b and 31a by means of a via 33 in the printed substrate 3 and wiring lines 32. The printed substrate 3 comprising the terminals 31a, 31b and 31c, LSI 60, flash memory (not shown) and the like is covered with a sheet 4 made of hard PVC (polyvinyl chloride) or the like.

The present preferred embodiment is characterised in that, of the terminals 31a, 31b and 31c used for connection to the host device, the terminal 31b for low-speed signal and the power-supply / ground terminal 31a are provided on a surface-layer side of the printed substrate 3, while the terminal 31a for high-speed signal is provided on an inner-layer side of the printed substrate 3 as illustrated in Fig. 9. More specifically, a level difference e is provided between the surface height position of each of the terminals 31b and 31a and the surface height position of the terminal 31c. In order to provide the level difference e, the present preferred embodiment is constituted as follows. In a portion of the printed substrate 3 below the terminal 31b for low-speed signal and the power-supply / ground terminal 31a (second-terminal setting portion 3b₂), a surface layer 3c of the printed substrate 3 is provided at the same position as the surface layer 3c of the printed substrate 3 for any other portions are provided. On the other hand, in a portion of the printed substrate 3 below the terminal 31c for high-speed signal (first-terminal setting portion 3b₁), the surface layer 3c is selectively removed. Because the surface layer 3c of the printed substrate is thus selectively removed, the second-terminal setting portion 3b₂ is higher in position than the first-terminal setting portion 3b₁, which forms the level difference e.

Accordingly, when the fingertips of the human body, or the like, contact the terminals 31a, 31b and 31a, they first contact the power-supply / ground terminal 31a and the terminal 31b for low-speed signal. Therefore, the static electricity accumulated in the human body flows through the terminal 31a and 31b into a second diode 62B provided in a second bypass wire 63B, and then is discharged through the second diode 62B to the stable potential, or is discharged through the power-supply / ground terminal 31a to the stable potential. As a result, the I/O circuit 61 of the LSI 60 can be protected from the static electricity.

The transmission rate in the transmission of the signal through the terminals 31b for low-speed signal is low, and the impedance mismatch in the transmission path is not a major concern. On the other hand, the transmission rate in the transmission of the signal through the terminals 31c for high-speed signal is high, and the impedance mismatch in the transmission path can be a serious problem. In view of this, the following constitution is provided in the present preferred embodiment as is the case with the preferred embodiment 1. In the second bypass wire 63B to which the terminals 31b for low-speed signal are connected, a second diode 62B having a sufficiently high pressure resistance and a large load capacity is provided. On the other hand, in a first bypass wire63A to which the terminals 31c for high-speed signal are connected, a first diode 62A having a reduced load pressure resistance and a small load capacity is provided. According to the constitution, the I/O circuit (I/O circuit for high-speed signal) of the LSI 60 can be protected from the intrusion of the static electricity while the impendance matching in the transmission path to which the terminals 31c for high-speed signal is connected is maintained.

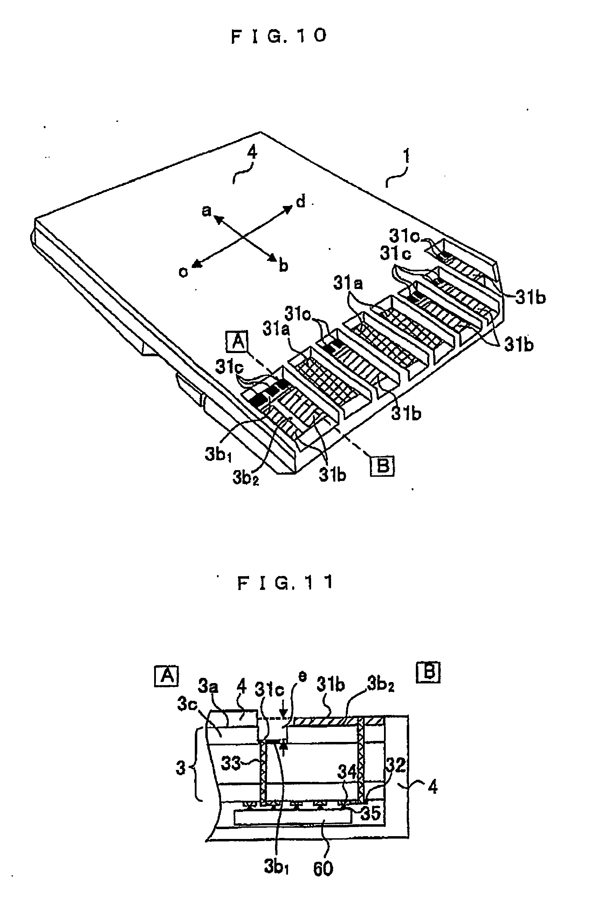

As illustrated in Figs. 10 and 11, the terminals 31b for low-speed signal may be provided on the end side of the removable memory card 1 along a direction in which the terminals are arranged, and the terminals 31c for high-speed signal may be provided on the center side of the removable memory card. By doing so, it can be more difficult for a human body, such as his/her fingertips, to contract the terminals 31c for high-speed signal. As a result, the I/O circuit (X/O circuit for high-speed signal) in the LSI 60 can be more effectively protected from the static electricity. The direction in which the terminals are arranged in the removable memory card 1 includes both of a - b direction and c - d direction illustrated in Fig. 10.

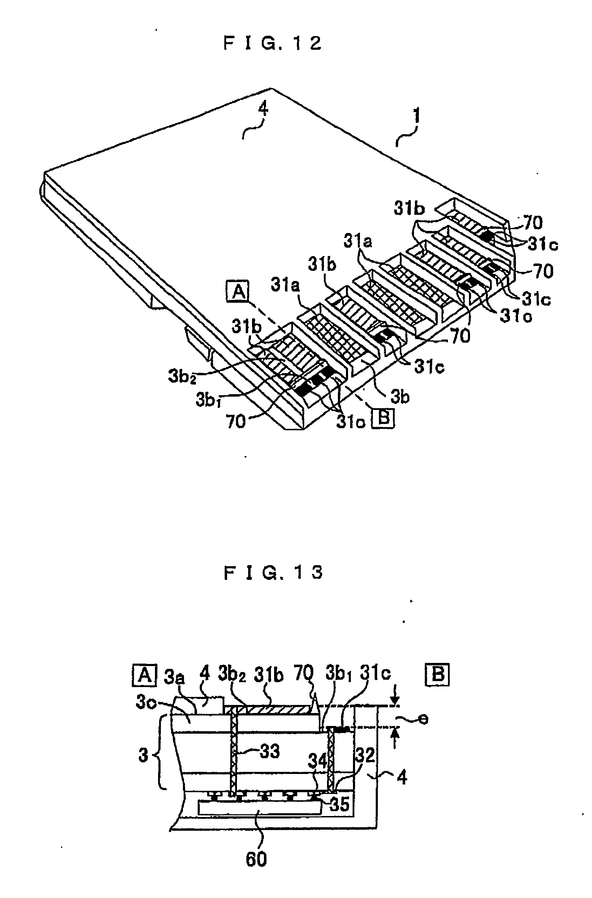

As illustrated in Figs. 12 and 13, partitions 70 having a larger height dimension than the peripheral portions and protruding upward from the printed substrate 3 may be provided between the terminals 31b for low-speed signal and the terminals 31c for high-speed signal adjacent to each other to make it more difficult for a human body, such as his/her fingertips, to contact the terminals 31c for high-speed signal. The partitions 70 may be provided such that the sheet 4 made of hard PVC or the like and serving as the cover of the removable memory card, for example, is modified. As a result, the I/O circuit (I/O circuit for high-speed signal) in the LSI 60, to which the terminals 31c for high-speed signal are connected, can be more effectively protected from the static electricity.

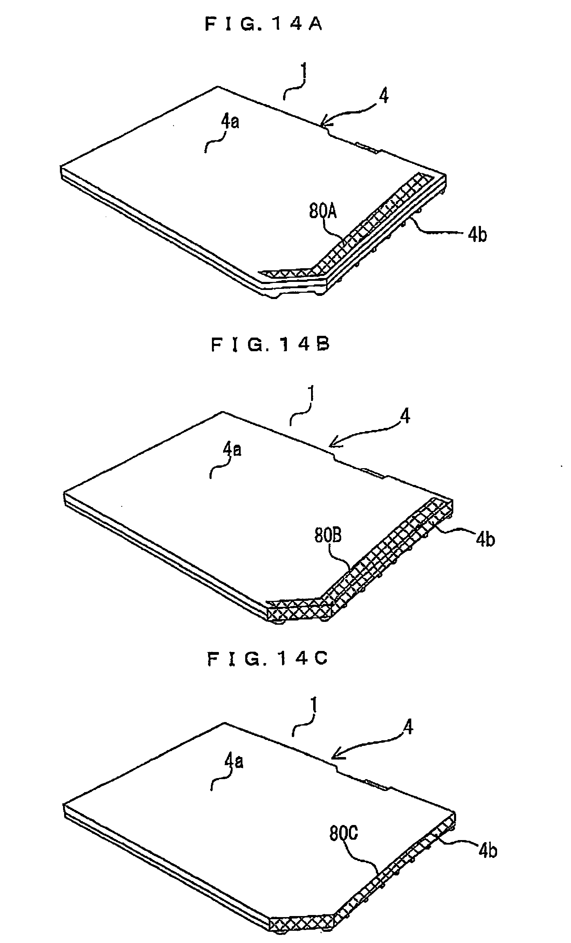

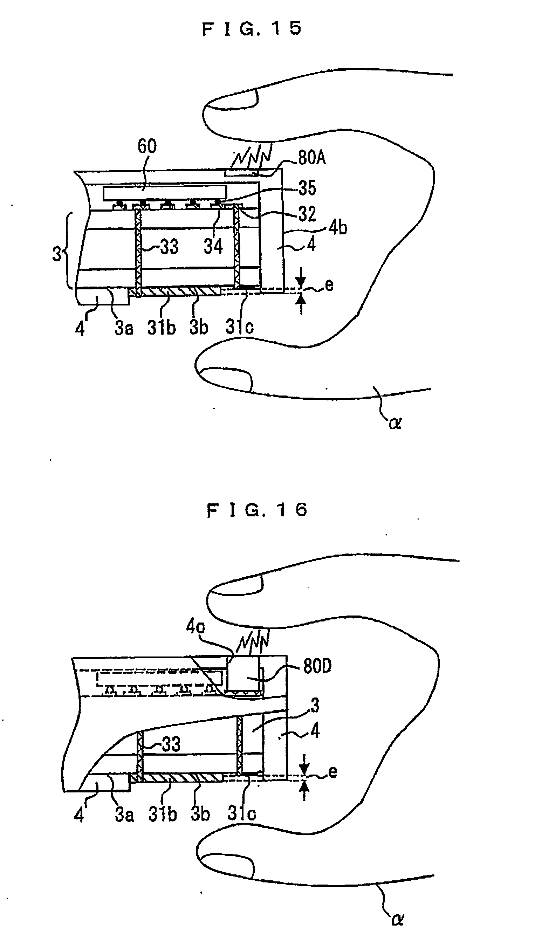

The constitutions according to the preferred embodiments described so far may further comprise a constitution illustrated in Figs. 14A, 14B, 14C and 15. This modified embodiment is characterized in that ground pads 80A - 80C are provided on a surface of the sheet 4. The ground pads 80A - 80C are provided on a surface facing the terminal formulation surface 3a of the printed substrate 3, namely, a sheet surface 4a or a sheet end surface 4b. Moreover, the ground pads 80A - 80C are provided along the sheet end surface 4b and in a shape extending over the entire length which covers positions facing the terminals 31a, 31b and 31c. Though not shown, the ground pads 80A - 80C are connected to the ground potential of the printed substrate 3.

Fig. 14A illustrates the ground pad 80A where a pattern is formed on the sheet surface 4a alone. Fig. 14B illustrates the ground pad 80B having a pattern continuous from the sheet surface 4a through the sheet end surface 4b. Fig. 14C illustrates the ground pad 80C where a pattern is formed on the sheet end surface 4b alone. The ground pads 80A - 80C are formed to be flush with the sheet surface 4a and the sheet end surface 4b. The ground pads 80A - 80C are made of a conductive material. More specifically, conducive foil (metal foil or the like), a plating layer, a conductive resin layer, sheet 4 in which a metal pad is insert-molded, a dual-mold member (a member in which conductive resin and insulating resin are mixed and molded) or the like may constitute the ground pads 80A - 80C.

In the case where the ground pads 80A - 80C thus constituted are provided, as illustrated in Fig. 15, the possibility is increased that user's fingertips α, or the like, contact the ground pads 80A - 80C before contacting the terminals 31a, 31b and 31c when the removable memory card 1 is used. Therefore, the static electricity accumulated in the user's body, which is an electrostatically-charged object, more easily flows through the ground pads 80A - 80C to the ground potential of the printed substrate 3, which makes it more difficult for the static electricity to flow toward the terminals 31a, 31b and 31c. Accordingly, the electrostatic protection performance can be improve. In Fig. 15, the example of the contact made by the fingertips or the like is described referring to the structure illustrated in Fig. 14A, and, the same contact manner applies to the structures illustrated in Figs. 14B and 14C.

As an alternative constitution, a ground pad 80D is provided on the printed substrate 3, and the ground pad 80D is exposed on the surface of the sheet 4 through a penetrating hole 4c formed in the sheet 4 as illustrated in Fig. 16.

## Claims

1. A removable memory card (1) comprising:
a printed substrate (3);
a first and second plurality of terminals (31c, 31b) for external connection provided on a terminal formation surface (3a) of the printed substrate (3); and
a first and second bypass wires (63A, 63B) provided on the printed substrate (3), the first and second bypass wiring (63A, 63B) dropping static electricity intruding into the first and second plurality of terminals respectively to a stable potential through respectively a first and a second plurality of electrostatic protection devices (62A, 62B), wherein
the second plurality of electrostatic protection devices (62B) provided in the second bypass wire (63B) connected to the second plurality of terminals (31b) have a load capacity larger than a load capacity of the first plurality of electro-static protection devices (62A) provided in the first bypass wire (63A) connected to the first plurality of terminals (31 c);
an LSI circuit (60) mounted on the printed substrate (3) and connected to the first and second plurality of terminals (31c, 31b), wherein
the height relative to the terminal formation surface (3a) of the first plurality of terminals (31a) is lower than the height relative to the terminal formation surface, of the second plurality of terminals (31b) on the terminal formation sur-face (3a),
the first and second plurality of terminals (31c, 31b) are terminals for inputting, outputting, or inputting and outputting a signal to an external device, and
a transmission rate of a signal transmitted through the first plurality of terminals (31a) is higher than a transmission rate of a signal transmitted through the second plurality of terminals (31b).

2. The removable memory card (1) as claimed in Claim 1, wherein surfaces of the first and second plurality of terminals (31c, 31b) are metal-plated, and
a thickness of the metal plating of the first plurality of terminals (31c) is smaller than a thickness of the metal plating of the second plurality of terminals (31b), and the height relative to the terminal formation surface (3a) of the first plurality of terminals (31c) is thereby lower than the height relative to the terminal formation surface (3a) of the second plurality of terminals (31b).

3. The removable memory card (1) as claimed in Claim 1, wherein
the terminal formation surface (3a) of the printed substrate (3) comprises a first terminal installation portion (3b1) in which the first plurality of terminals (31 c) is provided, and a second terminal installation portion (3b2) in which the second plurality of terminals (31b) is provided, and
the height position of the first terminal installation portion (3b1) is lower than the height position of the second terminal installation portion (3b2) on the terminal formation surface (3a), and the height relative to the terminal formation surface (3a) of the first plurality of terminals (31 c) is thereby lower than the height relative to the terminal formation surface (3a) of the second terminal (31 b).

4. The removable memory card (1) as claimed in Claim 1, wherein
the second plurality of terminals (31b) is provided closer to a card-end side of the removable memory card (1) along a direction in which the first and second plurality of terminals (31c, 31b) are arranged in comparison to the first plurality of terminals (31c).

5. The removable memory card (1) as claimed in Claim 1, wherein
a partition (70) protruding upward from the printed substrate (3) beyond the first and second plurality of terminals (31c, 31b) adjacent to each other is provided between these terminals.

6. The removable memory card (1) as claimed in Claim 1, further comprising a coating layer (4) covering the printed substrate (3), wherein
a ground pad (80A, 80B, 80C, 80D) connected to a ground potential of the printed substrate (3) is provided on at least one of a surface (4a) of the coating layer (4) facing the terminal formation surface (3a) or the end surface (4b) which connects the other surface (4a) of the coating layer (4) on the side of the terminal formation surface (3a) to the surface, and
the ground pad (80A, 80B, 80C, 80D) is provided in vicinity of the first and second plurality of terminals (31c, 31b).

7. The removable memory card (1) as claimed in Claim 6, wherein
a surface of the ground pad (80A, 80B, 80C) is flush with the surface of the coating layer (4).

8. The removable memory card (1) as claimed in Claim 6, wherein conductive foil constitutes the ground pad (80A, 80B, 80C).

9. The removable memory card (1) as claimed in Claim 6, wherein conductive resin constitutes the ground pad (80A, 80B, 80C).

10. The removable memory card (1) as claimed in Claim 6, wherein
a plating layer constitutes the ground pad (80A, 80B, 80C).

11. The removable memory card (1) as claimed in Claim 6, wherein
an insert-molded member constitutes the ground pad (80A, 80B, 80C).

12. The removable memory card (1) as claimed in Claim 6, wherein
a dual-mold member constitutes the ground pad (80A, 80B, 80C).

13. The removable memory card (1) as claimed in Claim 6, wherein
the ground pad (80D) is provided on the printed substrate, and
a penetrating hole (4c) through which the ground pad (80D) can be inserted is formed at a position of the coating layer (4) at which the ground pad (80D) is provided, and
the ground pad (80D) is exposed on a surface of the coating layer (4) through the penetrating hole (4c).

## Patentansprüche

1. Entfernbare Speicherkarte (1), Folgendes umfassend:
ein gedrucktes Substrat (3);
eine erste und eine zweite Mehrzahl von Anschlusspunkten (31 c, 31 b) für eine externe Verbindung, bereitgestellt auf einer Anschlusspunkt-Anordnungsfläche (3 a) des gedruckten Substrats (3); und
einen ersten und einen zweiten Überbrückungsdraht (63 A, 63 B), die auf dem gedruckten Substrat (3) vorgesehen sind, wobei der erste und der zweite Überbrückungsdraht (63 A, 63 B) Reibungselektrizität abgeben, welche jeweils in die erste und die zweite Mehrzahl von Anschlusspunkten eindringt, für ein stabiles Potential, durch jeweils eine erste und eine zweite Mehrzahl von elektrostatischen Schutzvorrichtungen (62 A, 62 B), wobei
die zweite Mehrzahl von elektrostatischen Schutzvorrichtungen (62 B), die in dem zweiten Überbrückungsdraht (63 B) vorgesehen ist und mit der zweiten Mehrzahl von Anschlusspunkten (31 b) verbunden ist, eine Ladungskapazität aufweist, die größer ist als eine Ladungskapazität der ersten Mehrzahl von elektrostatischen Schutzvorrichtungen (62 A), die in dem ersten Überbrückungsdraht (63 A) vorgesehen ist, der mit der ersten Mehrzahl von Anschlusspunkten (31 c) verbunden ist;
eine LSI-Schaltung (60), montiert auf dem geduckten Substrat (3) und verbunden mit der ersten und der zweiten Mehrzahl von Anschlusspunkten (31 c, 31 b), wobei
die Höhe, relativ zu der Anschlusspunkt-Anordnungsfläche (3 a) der ersten Mehrzahl von Anschlusspunkten (31 a), niedriger ist als die Höhe, relativ zu der Anschlusspunkt-Anordnungsfläche der zweiten Mehrzahl von Anschlusspunkten (31 b) auf der Anschlusspunkt-Anordnungsfläche (3 a),
wobei
die erste und zweite Mehrzahl von Anschlusspunkten (31 c, 31 b) Anschlusspunkte sind für das Eingeben, das Ausgeben oder das Eingeben und Ausgeben eines Signals zu einer externen Vorrichtung, und
eine Übertragungsrate eines Signals, das durch die erste Mehrzahl von Anschlusspunkten (31 a) übertragen wird, höher ist als eine Übertragungsrate eines Signals, das durch die zweite Mehrzahl von Anschlusspunkten (31 b) übertragen wird.

2. Entfernbare Speicherkarte (1) nach Anspruch 1, wobei
Oberflächen der ersten und der zweiten Mehrzahl von Anschlusspunkten (31 c, 31 b) einen metallplattierten Zustand aufweisen,
und
eine Dicke der Metallplattierung der ersten Mehrzahl von Anschlusspunkten (31 c) geringer ist als eine Dicke der Metallplattierung der zweiten Mehrzahl von Anschlusspunkten (31 b), und die Höhe, relativ zu der Anschlusspunkt-Anordnungsfläche (3 a) der ersten Mehrzahl von Anschlusspunkten (31 c), dadurch geringer ist als die Höhe, relativ zu der Anschlusspunkt-Anordnungsfläche (3 a) der zweiten Mehrzahl von Anschlusspunkten (31 b).

3. Entfernbare Speicherkarte (1) nach Anspruch 1, wobei
die Anschlusspunkt-Anordnungsfläche (3 a) des gedruckten Substrats (3) einen ersten Anschlusspunkt-Montageabschnitt (3 b 1) umfasst, in welchem die erste Mehrzahl von Anschlusspunkten (31 c) vorgesehen ist, und einen zweiten Anschlusspunkt-Montageabschnitt (3 b 2) umfasst, in welchem die zweite Mehrzahl von Anschlusspunkten (31 b) vorgesehen ist, und
die Höhenposition des ersten Anschlusspunkt-Montageabschnitts (3 b 1) niedriger ist als die Höhenposition des zweiten Anschlusspunkt-Montageabschnitts (3 b 2) auf der Anschlusspunkt-Anordnungsfläche (3 a), und die Höhe relativ zu der Anschlusspunkt-Anordnungsfläche (3 a) der ersten Mehrzahl von Anschlusspunkten (31 c) dadurch geringer ist als die Höhe relativ zu der Anschlusspunkt-Anordnungsfläche (3 a) des zweiten Anschlusspunktes (31b).

4. Entfernbare Speicherkarte (1) nach Anspruch 1, wobei
die zweite Mehrzahl von Anschlusspunkten (31b) im Vergleich zu der erste Mehrzahl von Anschlusspunkten (31c) näher an einer Karten-Endseite der entfernbaren Speicherkarte (1) entlang einer Richtung vorgesehen ist, in welcher die erste und die zweite Mehrzahl von Anschlusspunkten (31c, 31b) eingerichtet ist.

5. Entfernbare Speicherkarte (1) nach Anspruch 1, wobei
eine Partition (70) zwischen diesen Anschlusspunkten vorgesehen ist, die von dem gedruckten Substrat (3) nach oben über die erste und zweite Mehrzahl von angrenzend aneinander eingerichteten Anschlusspunkten (31c, 31b) hinaus hervorsteht.

6. Entfernbare Speicherkarte (1) nach Anspruch 1, ferner umfassend eine Überzugsschicht (4), die das gedruckte Substrat (3) überzieht, wobei
ein Massepunkt (80 A, 80 B, 80 C, 80 D), verbunden mit einem Massepotential des gedruckten Substrats (3), vorgesehen ist auf zumindest einer von einer Oberfläche (4 a) der Überzugsschicht (4), gegenüberliegend der Anschlusspunkt-Anordnungsfläche (3 a), und der Endfläche (4 b), welche die andere Oberfläche (4 a) der Überzugsschicht (4) auf der Seite der Anschlusspunkt-Anordnungsfläche (3 a) mit der Oberfläche verbindet, und
der Massepunkt (80 A, 80 B, 80 C, 80 D) vorgesehen ist in der Nähe der ersten und zweiten Mehrzahl von Anschlusspunkten (31 c, 31 b).

7. Entfernbare Speicherkarte (1) nach Anspruch 6, wobei
eine Oberfläche des Massepunktes (80 A, 80 B, 80 C) einen mit der Oberfläche der Überzugsschicht (4) bündigen Zustand aufweist.

8. Entfernbare Speicherkarte (1) nach Anspruch 6, wobei eine Leiterfolie den Massepunkt (80 A, 80 B, 80 C) bildet.

9. Entfernbare Speicherkarte (1) nach Anspruch 6, wobei ein leitfähiger Harz den Massepunkt (80 A, 80 B, 80 C) bildet.

10. Entfernbare Speicherkarte (1) nach Anspruch 6, wobei eine Plattierungsschicht den Massepunkt (80 A, 80 B, 80 C) bildet.

11. Entfernbare Speicherkarte (1) nach Anspruch 6, wobei ein geformtes Element den Massepunkt (80 A, 80 B, 80 C) bildet.

12. Entfernbare Speicherkarte (1) nach Anspruch 6, wobei ein zweifach geformtes Element den Massepunkt (80 A, 80 B, 80 C) bildet.

13. Entfernbare Speicherkarte (1) nach Anspruch 6, wobei der Massepunkt (80 D) auf dem gedruckten Substrat vorgesehen ist, und
ein Durchgangsloch (4 c), durch das der Massepunkt (80 D) eingeführt werden kann, an einer Position der Überzugsschicht (4) gebildet ist, an welcher der Massepunkt (80 D) vorgesehen ist, und
der Massepunkt (80 D) auf einer Oberfläche der Überzugsschicht (4) durch das Durchgangsloch (4 c) freiliegt.

## Revendications

1. Carte mémoire amovible (1) comprenant :
un substrat imprimé (3) ;
une première et une deuxième pluralité de bornes (31c, 31b) pour une connexion externe prévues sur une surface (3a) de formation de bornes du substrat imprimé (3) ; et
des premier et deuxième câbles de contournement (63A, 63B) prévus sur le substrat imprimé (3), les premier et deuxième câblages de contournement (63A, 63B) abaissant l'électricité statique s'introduisant dans la première et la deuxième pluralités de bornes respectivement à un potentiel stable par le biais d'une première et d'une deuxième pluralités, respectivement, de dispositifs de protection électrostatique (62A, 62B), où
la deuxième pluralité de dispositifs de protection électrostatique (62B) prévus dans le deuxième câble de contournement (63B) connecté à la deuxième pluralité de bornes (31b) ont une capacité de charge supérieure à une capacité de charge de la première pluralité de dispositifs de protection électrostatique (62A) prévus dans le premier câble de contournement (63A) connecté à la première pluralité de bornes (31c) ;
un circuit LSI (60) monté sur le substrat imprimé (3) et connecté à la première et à la deuxième pluralités de bornes (31c, 31b), où
la hauteur par rapport à la surface (3a) de formation de bornes de la première pluralité de bornes (31a) est inférieure à la hauteur par rapport à la surface de formation de bornes, de la deuxième pluralité de bornes (31b) sur la surface (3a) de formation de bornes,
où
les première et deuxième pluralités de bornes (31c, 31b) sont des bornes pour entrer, délivrer en sortie, ou entrer et délivrer en sortie, un signal à un dispositif externe, et
un débit de transmission d'un signal transmis à travers la première pluralité de bornes (31a) est supérieur à un débit de transmission d'un signal transmis à travers la deuxième pluralité de bornes (31b).

2. Carte mémoire amovible (1) telle que revendiquée dans la revendication 1, dans laquelle
des surfaces des première et deuxième pluralités de bornes (31c, 31b) sont à revêtement métallique, et
une épaisseur de revêtement métallique de la première pluralité de bornes (31c) est inférieure à une épaisseur du revêtement métallique de la deuxième pluralité de bornes (31b), et la hauteur par rapport à la surface (3a) de formation de bornes de la première pluralité de bornes (31c) est ainsi inférieure à la hauteur par rapport à la surface (3a) de formation de bornes de la deuxième pluralité de bornes (31b).

3. Carte mémoire amovible (1) telle que revendiquée dans la revendication 1, dans laquelle
la surface (3a) de formation de bornes du substrat imprimé (3) comprend une première partie (3b1) d'installation de bornes dans laquelle est prévue la première pluralité de bornes (31c), et une deuxième partie (3b2) d'installation de bornes dans laquelle est prévue la deuxième pluralité des bornes (31b), et
la position de hauteur de la première partie (3b1) d'installation de bornes est inférieure à la position de hauteur de la deuxième partie (3b2) d'installation de bornes sur la surface (3a) de formation de bornes, et la hauteur par rapport à la surface (3a) de formation de bornes de la première pluralité de bornes (31c) est ainsi inférieure à la hauteur par rapport à la surface (3a) de formation de bornes de la deuxième borne (31b).

4. Carte mémoire amovible (1) telle que revendiquée dans la revendication 1, dans laquelle
la deuxième pluralité de bornes (31b) est prévue de sorte à être plus proche d'un côté d'extrémité de la carte mémoire amovible (1) le long d'une direction dans laquelle les première et deuxième pluralités de bornes (31c, 31b) sont agencées en comparaison avec la première pluralité de bornes (31c).

5. Carte mémoire amovible (1) telle que revendiquée dans la revendication 1, dans laquelle
une partition (70) faisant saillie vers le haut depuis le substrat imprimé (3) au-delà des première et deuxième pluralités de bornes (31c, 31b) de manière adjacente l'une à l'autre est prévue entre ces bornes.

6. Carte mémoire amovible (1) telle que revendiquée dans la revendication 1, comprenant en outre une couche de revêtement (4) recouvrant le substrat imprimé (3), dans laquelle
un plot de terre (60A, 80B, 80C, 80D) connecté à un potentiel de masse du substrat imprimé (3) est prévu sur au moins l'une d'une surface (4a) de la couche de revêtement (4) en face de la surface (3a) de formation de bornes ou de la surface d'extrémité (4b) qui relie l'autre surface (4a) de la couche de revêtement (4) sur le côté de la surface (3a) de formation de bornes à la surface, et
le plot de terre (80A, 80B, 80C, 80D) est prévu à proximité des première et deuxième pluralités de bornes (31c, 31b).

7. Carte mémoire amovible (1) telle que revendiquée dans la revendication 6, dans laquelle
une surface du plot de terre (80A, 80B, 80C) affleure la surface de la couche de revêtement (4).

8. Carte mémoire amovible (1) telle que revendiquée dans la revendication 6, dans laquelle une feuille conductrice constitue le plot de terre (80A, 80B, 80C).

9. Carte mémoire amovible (1) telle que revendiquée dans la revendication 6, dans laquelle de la résine conductrice constitue le plot de terre (80A, 80B, 80C).

10. Carte mémoire amovible (1) telle que revendiquée dans la revendication 6, dans laquelle une couche de placage constitue le plot de terre (80A, 80B, 80C).

11. Carte mémoire amovible (1) telle que revendiquée dans la revendication 6, dans laquelle un élément moulé pour insertion constitue le plot de terre (80A, 80B, 80C).

12. Carte mémoire amovible (1) telle que revendiquée dans la revendication 6, dans laquelle un élément à double moule constitue le plot de terre (80A, 80B, 80C).

13. Carte mémoire amovible (1) telle que revendiquée dans la revendication 6, dans laquelle
le plot de terre (80D) est prévu sur le support imprimé, et
un trou de pénétration (4c) à travers lequel le plot de terre (80D) peut être inséré est formé au niveau d'une position de la couche de revêtement (4) à laquelle le plot de terre (80D) est prévu, et
le plot de terre (80D) est exposé sur une surface de la couche de revêtement (4) à travers le trou de pénétration (4c).
